Europäisches Patentamt

European Patent Office

Office européen des brevets

(11) Veröffentlichungsnummer: **0 262 480 B1**

(12) **EUROPÄISCHE PATENTSCHRIFT**

(45) Veröffentlichungstag der Patentschrift: 07.08.91

(51) Int. Cl.5: **H03F 3/345**, G05F 3/26

(21) Anmeldenummer: 87113204.9

(22) Anmeldetag: 09.09.87

(54) Stromspiegel-Schaltungsanordnung.

(30) Priorität: 24.09.86 DE 3632432

(43) Veröffentlichungstag der Anmeldung:
06.04.88 Patentblatt 88/14

(45) Bekanntmachung des Hinweises auf die
Patenterteilung:
07.08.91 Patentblatt 91/32

(84) Benannte Vertragsstaaten:
AT BE CH DE FR GB IT LI LU NL SE

(56) Entgegenhaltungen:
GB-A- 2 071 951
US-A- 3 904 976
US-A- 4 524 328

PATENT ABSTRACTS OF JAPAN, Band 3, no.
155, 19. Dezember 1979, Seite 128 E 160; &
JP-A-54 136 261 (NIPPON DENKI K.K.)
23-10-1979

(73) Patentinhaber: Siemens Aktiengesellschaft
Wittelsbacherplatz 2
W-8000 München 2(DE)

(72) Erfinder: Draxelmayr, Dieter, Dipl.-Ing.
Heidenfeldstrasse 17
A-9500 Villach(AT)

## Beschreibung

Die Erfindung betrifft eine Stromspiegel-Schaltungsanordnung nach dem Oberbegriff des Patentanspruchs 1.

Stromspiegel-Schaltungen kommen vor allem in integrierter Schaltungstechnik in nahezu allen Analogschaltungen vor. Bei einem einfachen Stromspiegel, der meistens aus zwei Transistoren besteht, von denen einer als Diode geschaltet ist und die über ihren Steueranschluß miteinander verbunden sind, ist der Ausgangsstrom von der Ausgangsspannung abhängig, d.h. der Stromspiegel weist einen geringen differentiellen Ausgangswiderstand auf.

Zur Erhöhung des differentiellen Ausgangswiderstandes gibt es mehrere Möglichkeiten. Erstens kann die Kanallänge des Spiegeltransistors, durch den der Ausgangsstrom fließt, vergrößert werden. Diese Methode ist jedoch nur für kleine Transistoren und kleine Ströme wirksam, da mit steigenden Anforderungen auch die Kanalweite erhöht werden muß und somit der Flächenbedarf des Transistors überproportional steigt. Eine andere Möglichkeit besteht darin, die Spiegeltransistoren zu kaskadieren, wodurch zwar der differentielle Ausgangswiderstand stark vergrößert wird, aber auch eine höhere Spannungreserve bzw. Arbeitsspannung zur Verfügung gestellt werden muß, da die Transistoren in Sättigung betrieben werden.

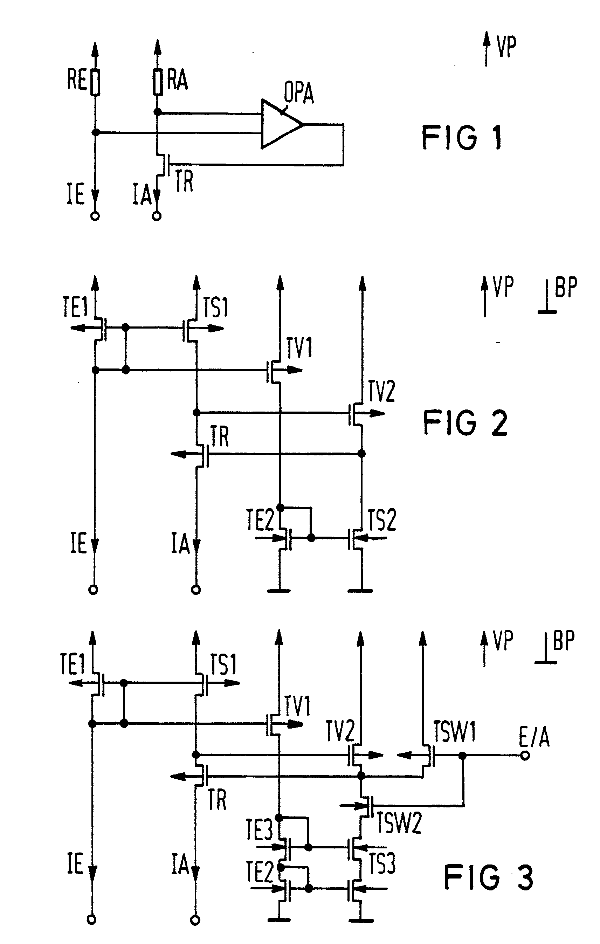

Eine dritte Möglichkeit (s.z.B.: PATENT ABSTRACTS OF JAPAN, Band 3, no. 155, 19. Dezember 1979, Seite 128 E 160; & JP-A-54 136 261 (NIPPON DENKI K.K.) 23-10-1979) besteht in der Verwendung eines Operationsverstärkers, wie im Ausführungsbeispiel gemäß Fig. 1 dargestellt ist. Der Stromspiegel besteht aus dem Eingangswiderstand RE und dem Ausgangswiderstand RA, die gemeinsam an einem Versorgungspotential VP angeschlossen sind und durch die der Eingangsstrom IE bzw. der Ausgangsstrom IA fließt. Die Potentiale der lastseitigen Anschlüsse der beiden Widerstände werden mit Hilfe eines Operationsverstärkers OPA verglichen, dessen Ausgang einen Regeltransistor TR steuert, der mit seinem Ausgangskreis in Reihe zum Widerstand RA liegt.

Mit der Schaltung gemäß Fig. 1 ist ein hoher differentieller Ausgangswiderstand erreichbar. Auch die Restspannung, d.h. die Spannung zwischen dem Versorgungspotential und dem lastseitigen Ausgangsanschluß des Regeltransistors TR, kann niedrig gehalten werden. Allerdings erfordert der Operationsverstärker OPA einen nicht unwesentlich höheren Schaltungsaufwand, und gleichzeitig wird die Dynamik der Stromspiegelschaltung von der Dynamik des Operationsverstärkers bestimmt, die im Vergleich zu einfachen Stromspiegelschaltungen schlecht ist.

Der Erfindung liegt die Aufgabe zugrunde, eine einfache Stromspiegelschaltung mit geringem Restspannungsabfall und hohem differentiellem Ausgangswiderstand bei guter Dynamik anzugeben.

Diese Aufgabe wird bei einer Schaltungsanordnung der eingangs genannten Art erfindungsgemäß durch die Merkmale des kennzeichnenden Teils des Patentanspruchs 1 gelöst.

Weitere Ausgestaltungen des Erfindungsgedankens sind in Unteransprüchen gekennzeichnet.

Die Erfindung wird im folgenden anhand von den in den Figuren der Zeichnung dargestellten Ausführungsbeispielen näher erläutert. Dabei sind gleiche Elemente mit gleichen Bezugszeichen versehen. Es zeigt:

Fig. 1 die bereits beschriebene bekannte Stromspiegelanordnung,

Fig. 2 ein Ausführungsbeispiel einer erfindungsgemäßen Stromspiegel-Schaltungsanordnung und

Fig. 3 ein weiteres Ausführungsbeispiel einer erfindungsgemäßen Stromspiegel-Schaltungsanordnung mit kaskadiertem Vergleichsstromspiegel und einer Möglichkeit zum Ein- und Ausschalten des gesamten Stromspiegels.

Gemäß Fig. 2 sind die beiden in Fig. 1 den Stromspiegel bildenden Widerstände durch Transistoren TE1 und TS1 ersetzt. Diese beiden Transistoren bilden bereits einen Stromspiegel, da ihre Steueranschlüsse miteinander verbunden sind, der Transistor TE1 als Diode geschaltet ist und jeweils ein Ausgangsanschluß der beiden Transistoren am Versorgungspotential VP angeschlossen ist. Während also durch den Transistor TE1 der Eingangsstrom IE fließt, fließt durch den Spiegeltransistor TS1 der Ausgangsstrom IA, wobei in Reihe zum Ausgangskreis des Transistors TS1 der Ausgangskreis des Regeltransistors TR liegt.

Der Stromspiegel aus den beiden Transistoren TE1 und TS1 arbeitet dann ideal, wenn alle entsprechenden Transistorspannungen identisch sind. Dann wird ein Ausgangsstrom IA erzwungen, der nur abhängig vom Übersetzungsverhältnis der Transistoren ist. Aufgrund der gegenständlichen schaltungstechnischen Realisierung sind gemäß Fig. 2 das Gate- und Source-Potential bereits jeweils identisch. Ebenso sind bei einer Ausführung in integrierter Schaltungstechnik die Bulkpotentiale identisch.

Erfindungsgemäß wird nun das Drain-Potential des Transistors TS1 mit Hilfe des Regeltransistors TR auf Identität mit dem Drain-Potential des Transistors TE1 geregelt. Dazu steuern die beiden Drain-Potentiale der Transistoren TE1 und TS1 die Steuereingänge zweier weiterer Transistoren TV1 und TV2, die mit jeweils einem Ausgangsanschluß ebenfalls am Vesorgungspotential VP angeschlossen sind. Der andere Ausgangsanschluß des Transistors TV2 steuert den Eingang des Regeltransistors TR, so daß ein rückgekoppelter Regelkreis entsteht. Die Ausgangskreise der Transistoren TV1 und TV2 liegen jeweils in Serie zu den Ausgangskreisen weiterer Transistoren TE2 und TS2, die einen weiteren Stromspiegel bilden. Dazu ist der Transistor TE2 als Diode geschaltet.

Der Schaltungteil, der für die Rückkopplung erforderlich ist, nämlich die Transistoren TV1, TV2, TE2 und TS2, bildet eine operationsverstärkerähnliche Struktur, die bereits funktionell in die eigentliche Stromspiegel-Schaltungsanordnung integriert ist, so daß keine Biasstufen bzw. Potentialanpassungsstufen erforderlich sind. Der Rückkopplungs-Schaltungsteil aus dem weiteren Stromspiegel und den Vergleichstransistoren TV1 und TV2 ist dann im Gleichgewicht, wenn die Gate-Potentiale von TV1 und TV2 gleich sind. Das bedeutet dann aber auch, daß die Drain-Potentiale der Transistoren TE1 und TS1 ebenfalls gleich sind. Dieser Rückkopplungs- und Regelmechanismus funktioniert auch, wenn der Regeltransistor TR im Widerstandsbereich betrieben wird, womit sich eine geringere Spannung als bei einer Kaskadierung ergibt.

Sinkt beispielsweise das Drain-Potential des Transistors TS1 aufgrund eines höheren Ausgangsstroms IA gegenüber dem Drain-Potential des Transistors TE1 ab, so leitet der Transistor TV2 besser und am Gate-Anschluß des Regeltransistors TR tritt eine höhere Spannung auf, die den Ausgangsstrom des Regeltransistors und damit den Ausgangsstrom IA des Stromspiegels reduziert. Die Transistoren TE1 und TS1 des Stromspiegels sowie die Transistoren TV1 und TV2 sind vom gleichen Typ, im Ausführungsbeispiel p-Kanal-Typen, während die Transistoren TE2 und TS2 des weiteren Stromspiegels vom andern Typ, d.h. vom n-Kanal-Typ sind. Somit können jeweils einer der Ausgangsanschlüsse der Transistoren TE1, TS1, TV1 und TV2 am Bezugspotential VP liegen, wodurch, wie gesagt, Biasstufen für die Regelung nicht erforderlich sind.

Fig. 3 gibt eine weitere Ausführungsform einer erfindungsgemäßen Stromspiegel-Schaltungsanordnung an, die sich von Fig. 2 dadurch unterscheidet, daß in Serie zu dem weiteren Stromspiegel aus den Transistoren TE2 und TS2 ein zusätzlicher Stromspiegel aus den Transistoren TE3 und TS3 befindet, wobei diese Transistoren sämtlich vom n-Kanal-Typ sind. Der Tranistor TE3 ist als Diode geschaltet. Dadurch ergibt sich für den weiteren Stromspiegel, der ja als Vergleichsstromspiegel dient, ein hoher differentieller Ausgangswiderstand, der eine höhere Verstärkung und somit eine höhere Genauigkeit bewirkt, während die Restspannung bei diesem Vergleichsstromspiegel keine maßgebliche Rolle einnimmt.

Des weiteren unterscheidet sich das Ausführungsbeispiel gemäß Fig. 3 von der Fig. 2 dadurch, daß parallel zum Ausgangskreis des Transistors TV 2 und in Serie zu den Ausgangskreisen der Transistoren TS2 und TS3 der Ausgangskreis der Transistoren TSW1 bzw. TSW2 angeordnet ist, die mit ihrem Steueranschluß miteinander und mit einer Klemme E/A verbunden sind. Der Tranistor TSW1 ist vom p-Kanal-Typ, während der Transistor TSW2 vom n-Kanal-Typ ist und ausgangsseitig zwischen den Ausgangskreisen der Tranistoren TV2 und TS3 liegt. Mit Hilfe dieser beiden Schaltertransistoren TSW1 und TSW2 kann die erfindungsgemäße Schaltungsanordnung in ihrem normalen Betriebsmodus betrieben werden oder aber abgeschaltet werden. Dazu wird mit Hilfe eines Steuerpotentials an der Kleme E/A entweder der Transistor TSW2 durchgesteuert, während dann der Transistor TSW1 sperrt oder aber der Transistor TSW1 wird durchgesteuert, so daß sich dann gleichzeitig der Transistor TSW2 und der Regeltransistor TR im Sperrzustand befinden.

## Patentansprüche

1. Stromspiegel-Schaltungsanordnung mit einen Stromspiegel aus einem als Diode geschalteten Eingangstransistor und einem Spiegeltransistor, die mit ihren Gate-Anschlüssen miteinander und mit jeweils einem Ausgangsanschluß mit einem Versorgungspotential verbunden sind, und mit einem Regeltransistor, dessen Ausgangskreis in Serie zum Ausgangskreis des Spiegeltransistors liegt, **dadurch gekennzeichnet**, daß die anderen Ausgangsanschlüsse des Eingangs- (TE1) und Spiegeltransistors (TS1) jeweils einen weiteren Transistor (TV1, TV2) steuern, von denen einer auf den Regeltransistor (TR) rückgekoppelt ist und die in den Ausgangskreisen von Transistoren einer weiteren Stromspiegelschaltung (TE2, TS2) liegen.

2. Stromspiegel nach Anspruch 1, **dadurch gekennzeichnet**, daß jeweils ein Ausgangsanschluß der weiteren Transistoren (TV1, TV2) mit dem Versorgungspotential (VP) verbunden ist.

3. Stromspiegel nach Anspruch 1 oder 2, **dadurch gekennzeichnet**, daß die Transistoren des Stromspiegels (TE1, TS1) und die weiteren Transistoren (TV1, TV2) vom einen Typ und die Transistoren der weiteren Stromspiegelschaltung (TE2, TS2; TE3, TS3) vom komplementären Typ sind.

4. Stromspiegel nach Anspruch 1 bis 3, **dadurch gekennzeichnet**, daß der Regeltransistor (TR) vom anderen Ausgangsanschluß desjenigen weiteren Transistors (TV2) gesteuert wird, der ausgangsseitig in Reihe zum Ausgangskreis des Spiegeltransistors (TS2, TS3) der weiteren Stromspiegelschaltung liegt.

5. Stromspiegel nach Anspruch 1 bis 4, **dadurch gekennzeichnet**, daß in Reihe zur weiteren Stromspiegelschaltung (TE2, TS2) eine zusätzliche Stromspiegelschaltung (TE3, TS3) angeordnet ist.

6. Stromspiegel nach Anspruch 1 bis 5, **dadurch gekennzeichnet**, daß eine Abschaltung vorgesehen ist, wozu parallel zum Ausgangskreis des den Regeltransistor (TR) steuernden weiteren Transistors (TV2) und in Reihe zum Ausgangskreis des Spiegeltransistors der weiteren oder zusätzlichen Stromspiegelschaltung (TS2, TS3) jeweils der Ausgangskreis zusätzlicher Tranistoren (TSW1, TSW2) von unterschiedlichem Typ liegt, deren Gate-Anschlüsse verbunden sind und im Sinne wechselseitigen Abschaltens gesteuert werden.

## Claims

1. Current balancing circuit arrangement with a current balancing circuit of a diode-connected input transistor and a balancing transistor, which are connected with their gate terminals to one another and with in each case one output terminal to a supply potential, and having a regulating transistor, the output circuit of which is connected in series with the output circuit of the balancing transistor, characterised in that the other output terminals of the input transistor (TE1) and balancing transistor (TS1) in each case control a further transistor (TV1, TV2), one of which is coupled back to the regulating transistor (TR), and which are located in the output circuits of transistors of a further current balancing circuit (TE2, TS2).

2. Current balancing circuit according to Claim 1, characterised in that in each case one output terminal of the further transistors (TV1, TV2) is connected to the supply potential (VP).

3. Current balancing circuit according tc Claim 1 or 2, characterised in that the transistors of the current balancing circuit (TE1, TS1) and the further transistors (TV1, TV2) are of one type and the transistors of the further current balancing circuit (TE2, TS2; TE3, TS3) are of the complementary type.

4. Current balancing circuit according to Claim 1 to 3, characterised in that the regulating transistor (TR) is controlled by the other output terminal of that further transistor (TV2) which is connected at its output in series with the output circuit of the balancing transistor (TS2, TS3) of the further current balancing circuit.

5. Current balancing circuit according to Claim 1 to 4, characterised in that an additional current balancing circuit (TE3, TS3) is arranged in series with the further current balancing circuit (TE2, TS2).

6. Current balancing circuit according to Claim 1 to 5, characterised in that a disconnecting arrangement is provided, for which purpose the output circuit of additional transistors (TSW1, TSW2) of a different type, the gate terminals of which are connected and are controlled in the sense of an alternating disconnection, is in each case located in parallel with the output circuit of the further transistor (TV2) controlling the regulating transistor (TR) and in series with the output circuit of the balancing transistor of the further or additional current balancing circuit (TS2, TS3).

## Revendications

1. Montage à miroir de courant comportant un miroir de courant formé d'un transistor d'entrée branché en diode et d'un transistor symétrique du précédent, les bornes de grille de ces transistors sont raccordées entre elles, tandis que les bornes respectives de sortie de ces transistors sont raccordées à un potentiel d'alimentation, et comportant un transistor de réglage, dont le circuit de sortie est branché en série avec le circuit de sortie du transistor symétrique, caractérisé par le fait que les autres bornes de sortie du transistor d'entrée (TE1) et du transistor symétrique (TS1) commandent respectivement d'autres transistors (TV1,TV2), dont l'un est couplé par réaction au transistor de réglage (TR) et qui sont situés dans les circuits de sortie de transistors d'un autre circuit formant miroir de courant (TE2, TS2).

2. Miroir de courant suivant la revendication 1, caractérisé par le fait que respectivement une borne de sortie des autres transistors (TV1,TV2) est raccordée au potentiel d'alimentation (VP).

3. Miroir de courant suivant la revendication 1 ou 2, caractérisé par le fait que les transistors du miroir de courant (TE1, TS1) et les autres transistors (TV1, TV2) sont d'un type et les transistors de l'autre circuit formant miroir de courant (TE2,TS2; TE3,TS3) sont du type complémentaire.

4. Miroir de courant suivant l'une des revendications 1 à 3, caractérisé par le fait que le transistor de réglage (TR) est commandé par l'autre borne de sortie de l'autre transistor (TV2), dont le côté sortie est branché en série avec le circuit de sortie du transistor symétrique (TS2,TS3) de l'autre circuit formant miroir de courant.

5. Miroir de courant suivant les revendications 1 à 4, caractérisé par le fait qu'un circuit formant miroir de courant supplémentaire (TE3,TS3) est monté en série avec l'autre circuit formant miroir de courant (TE2,TS2).

6. Miroir de courant suivant les revendications 1 à 5, caractérisé par le fait qu'il est prévu un débranchement et qu'à cet effet respectivement le circuit de sortie de transistors supplémentaires (TSW1 et TSW2) d'un type différent, dont les bornes de grille sont réunies et sont commandées dans le sens d'un débranchement alterné, est branché en parallèle avec le circuit de sortie de l'autre transistor (TV2), qui commande le transistor de réglage (TR), et en série avec le circuit de sortie du transistor symétrique de l'autre circuit formant miroir de courant ou du circuit supplémentaire formant miroir de courant (TS2, TS3).

FIG 1

FIG 2

FIG 3